Europäisches Patentamt

European Patent Office

Office européen des brevets

(19)

(11) **EP 0 651 477 B1**

(12) **FASCICULE DE BREVET EUROPEEN**

(45) Date de publication et mention
de la délivrance du brevet:
**01.10.1997   Bulletin 1997/40**

(51) Int Cl.$^6$: **H01S 3/085**

(21) Numéro de dépôt: **94402423.1**

(22) Date de dépôt: **27.10.1994**

(54) **Dispositif laser intégré à émission de surface**

Integrierte oberflächenemittierende Laservorrichtung

Integrated surface emitting laser device

(84) Etats contractants désignés:
**DE FR GB**

(30) Priorité: **29.10.1993   FR 9312940**

(43) Date de publication de la demande:
**03.05.1995   Bulletin 1995/18**

(73) Titulaire: **FRANCE TELECOM**
**75015 Paris (FR)**

(72) Inventeur: **Bouley, Jean-Claude**
**F-94110 Arcueil (FR)**

(74) Mandataire: **Dubois-Chabert, Guy et al**
**Société de Protection des Inventions**
**25, rue de Ponthieu**
**75008 Paris (FR)**

(56) Documents cités:
**US-A- 4 675 876**          **US-A- 5 052 016**

- **ELECTRONICS LETTERS, vol.27, no.13, 20 Juin 1991, Stevenage, Herts, GB, pp 1120-1121; T. MAKINO: 'Analysis of below threshold spectrum and linewidth of surface emitting lamda/4 shifted DFB lasers with DBR mirror'**
- **APPLIED PHYSICS LETTERS, vol.51, no.21, 23 Novembre 1987, New York, US, pp 1655-1657; M. OGURA ET AL.: 'Surface emitting laser diode with vertical GaAs/AlGaAs quarter wavelength multilayers and lateral buried heterostructure'**
- **ELECTRONICS LETTERS, vol.26, no.1, 4 Janvier 1990, Stevenage, Herts, GB, pp 18-19; M. OGURA ET AL.: 'Surface emitting laser diode with distributed bragg reflector and buried heterostructure'**
- **ELECTRONICS LETTERS, vol.27, no.24, 21 Novembre 1991, Stevenage, Herts, GB, pp 2243-2245; E.M. CLAUSSEN: 'Improved threshold characteristics of air-post vertical cavity surface emitting lasers using unique etching process'**
- **IEEE PHOTONICS TECHNOLOGY LETTERS, vol.1, no.3, Mars 1989, New York, US, pp 52-54; S.W. CORZINE ET AL.: 'Efficient narrow linewidth DBR surface emitting laser with periodic gain'**

## Description

La présente invention a pour objet un dispositif laser intégré à émission de surface comprenant une cavité optique verticale. On entend par cavité verticale une cavité perpendiculaire au substrat sur lequel elle est réalisée, par opposition aux cavités horizontales telles que celles des lasers à ruban, qui sont parallèles au substrat. Les lasers à cavité verticale présentent une face d'émission de lumière parallèle au substrat, que l'on désigne par face frontale dans la suite du texte.

Les lasers à émission de surface connaissent depuis quelques années un développement important, notamment en raison de leurs caractéristiques particulièrement intéressantes par rapport aux diodes lasers classiques à ruban émettant par la tranche. L'émission par la surface facilite notamment le couplage des diodes lasers avec des fibres optiques, leur intégration bidimentionnelle et également le triage des puces en pleine plaque.

Comme l'explique le document (1) "La révolution des diodes laser à cavité verticale" de M. Labachèlerie dans "Japon Optoelectronique" n°14, p.16 et suivantes, différents dispositifs laser à ruban comportant des moyens de renvoi vertical de la lumière ont été imaginés. Ces dispositifs comportent, par exemple, un miroir à 45° usiné dans le substrat portant le ruban, ou un réseau de diffraction. En raison des difficultés liées à l'usinage d'un tel miroir et à la réalisation de réseaux de diffraction ainsi qu'en raison du volume trop important de ces dispositifs, ceux-ci cèdent peu à peu leur place à des lasers à cavité verticale du type VCSEL (de l'anglais *Vertical Cavity Surface Emitting Laser*).

Les lasers à cavité verticale VCSEL sont des émetteurs très directifs avec un faisceau de type gaussien et ont l'avantage d'un fonctionnement monofréquence très stable.

Ces lasers comportent pour la plupart une cavité optique en un matériau semiconducteur massif ou à puits quantiques avec des miroirs épitaxiés ou rapportés de manière à réaliser une structure de type Pérot-Fabry. Comme cela ressort du document (1), on réalise des miroirs de très forte réflectivité pour pouvoir former des couches actives les plus fines possibles. Des couches actives fines permettent de limiter le courant requis pour obtenir l'amplification tandis que des miroirs de bonne réflectivité compensent la perte de gain due à l'épaisseur faible de la couche active. Le courant est injecté de manière verticale à travers les miroirs. La tension au seuil relativement élevée de ces lasers est due particulièrement à la résistance très élevée des miroirs réalisés en général par une succession alternée de couches de composés d'aluminium et d'arsenic et de couches de composés de gallium, d'aluminium et d'arsenic. La qualité de ces miroirs est excellente mais leur conductivité électrique est limitée par celle de l'alliage AsAl et par des barrières de potentiel produites aux interfaces des couches. Des miroirs constitués d'une alternance de couches de composés d'indium et de phosphore et d'indium (InP), d'arsenic et de phosphore (InAsP), ont également été essayés mais les empilements nécessaires sont plus épais et la réflectivité est moindre.

Le document (2) "Efficient, Narrow-Linewidth Distributed Bragg-Reflector Surface Emitting Laser with Periodic Gain" publié dans IEEE Photonic Technology présente une alternative de réalisation de laser VCEL et apporte une solution à l'injection du courant.

D'épaisses couches alternativement de matériau dopé p ou n, séparées par des zones optiquement actives, injectent dans ces zones les porteurs électriques, tandis qu'elles sont elles-mêmes alimentées par des amenées de courant latérales en matériau semi-conducteur. La réaction optique est réalisée également au moyen de miroirs quart d'onde de type DBR (*Distruted Bragg Reflexion*).

Ces dispositifs sont relativement complexes à réaliser, et présentent des effets parasites de rétroaction distribuée le long de la structure qui interfèrent avec la réflexion de Bragg des miroirs.

Le but de la présente invention est d'apporter une solution aux inconvénients des dispositifs laser exposés et de fournir un nouveau dispositif laser, de réalisation très simple, qui soit intégrable avec des densités très grandes et qui permette une injection facile des porteurs.

Un autre but de l'invention est de réduire la tension au seuil du laser.

A cet effet, l'invention concerne un laser intégré à émission par la surface comportant un substrat et une cavité optique à rétroaction distribuée présentant au moins une face latérale perpendiculaire au substrat et au moins une face d'émission de lumière parallèle au substrat, la cavité comprenant un empilement de couches semi-conductrices de différents indices de réfraction, avec des régions optiquement actives et la face latérale étant enrobée par un revêtement semi-conducteur, caractérisé en ce que le revêtement et le substrat sont respectivement en contact électrique avec des électrodes formées sur le revêtement et sur une face libre du substrat pour appliquer une tension entre le revêtement et le substrat, le revêtement formant ainsi un moyen d'injection d'un courant de porteurs électriques dans les régions optiquement actives, par la face latérale de la cavité, et le courant de porteurs électriques s'écoulant vers le substrat à travers la cavité.

Un laser selon le préambule de la revendication 1 de la présente invention est connu de US-A-4 675 876 ou US-A-5 052 016.

Un effet de rétroaction distribuée ou DBF *(Distributed Feed-Back* en terminologie anglo-saxonne) est recherché et mis à profit pour réaliser la contre réaction optique nécessaire à l'établissement d'une onde stationnaire. Ainsi, l'utilisation de miroirs et d'une structure de Pérot-Fabry n'est plus nécessaire. La cavité comporte un empilement alterné de couches semi-conductrices de différents indices de réfraction et ledit empilement comprend des régions optiquement actives.

L'alternance de couches d'indices différents crée un réseau optique. Le réseau provient de marches d'indice périodiquement répétées (réseau d'indice).

L'empilement peut être formé par exemple par une superposition de couches semi-conductrices selon un ordre et des séquences définis.

Selon une version préférée de l'invention, l'empilement comporte des paires de couches formées chacune d'une première couche d'un premier matériau semi-conducteur ayant une première bande interdite $E_1$ et un premier indice de réfraction $n_1$, et d'une deuxième couche d'un second matériau semi-conducteur ayant une deuxième bande interdite $E_2$ et un deuxième indice de réfraction $n_2$ différent du premier indice de réfraction $n_1$ du premier matériau, ladite couche de premier matériau de chaque paire constituant une des régions optiquement actives du laser.

Les régions actives génèrent un gain optique à la longueur d'onde associée à la largeur de la bande interdite $E_1$, tandis qu'à chaque interface entre une couche de premier matériau et une couche de second matériau ($E_1$, $E_2$) une partie de l'onde lumineuse produite et réfléchie dans la direction opposée à sa propagation en raison de la marche d'indice $n_1$-$n_2$ entre ces matériaux. Ce phénomène, bien que dominé par la différence d'indice réel des couches $n_1$-$n_2$, est encore renforcé par une contribution due à une différence d'indice imaginaire induite par le gain dans les régions actives. Il apparaît une onde stationnaire résultant de la superposition de deux ondes verticales se propageant de haut en bas et réciproquement.

Pour optimiser le fonctionnement de la cavité dont la longueur est définie par le nombre de paires de couches semi-conductrices, l'épaisseur $\Lambda$ de chaque paire de couches est choisie telle que $\Lambda = \frac{\lambda}{2 n_{eff}}$ où $\lambda$ est la longueur d'onde de Bragg du réseau d'indice formé par l'empilement des couches et où $n_{eff}$ est l'indice effectif de propagation de la lumière dans la cavité dans une direction perpendiculaire aux couches. L'indice $n_{eff}$ est en fait compris entre $n_1$ et $n_2$.

Le confinement de la lumière dans la cavité, selon une direction perpendiculaire aux couches, est obtenu grâce à un revêtement enrobant les faces latérales de la cavité. Le revêtement est réalisé en un matériau semi-conducteur de bande interdite $E_3$ et d'indice de réfraction $n_3$ inférieur aux indices $n_1$ et $n_2$.

Comme mentionné ci-dessus, le revêtement constitue un moyen d'injection de porteurs électriques dans les régions actives de la cavité par les faces latérales. Le matériau du revêtement est effectivement choisi de sorte que la bande interdite $E_3$ soit plus grande que les bandes interdites $E_1$ et $E_2$ du premier et du second matériau.

Le type de conduction du matériau du revêtement est opposé au type de conduction des premier et second matériaux. Par exemple, le matériau du revêtement est de type p alors que les premier et second matériaux sont de type n.

L'injection de porteurs minoritaires dans les couches du premier matériau, qui a la plus petite bande interdite $E_1$ a lieu en appliquant une tension positive entre le substrat et le matériau semi-conducteur du revêtement.

A cet effet, une première électrode est constituée d'une couche conductrice que l'on dépose sur la face inférieure du substrat qui ne porte pas la cavité, et une seconde électrode est constituée d'une couche conductrice déposée sur le revêtement.

Ces couches conductrices peuvent, si nécessaire, comporter des ouvertures en regard de la cavité afin de laisser passer la lumière émise. On peut noter que la lumière peut être émise soit par la face frontale supérieure de la cavité constituée par la dernière couche de l'empilement, soit par une face frontale constituée par la première couche de l'empilement, c'est-à-dire celle qui est en contact avec le substrat soit encore par ces deux faces à la fois. Le substrat est, selon le cas, choisi transparent à la longueur d'onde de l'émission.

Selon une variante de l'invention, le laser peut en outre comporter des moyens de réflexion externes à la cavité par exemple sur la face inférieure du substrat, parallèles à la face sur laquelle est réalisée la cavité. Ces moyens sont destinés à réaliser une réaction optique supplémentaire.

Les moyens de réflexion peuvent être par exemple un réseau réflecteur de Bragg constitué d'un empilement de couches diélectriques, de type quart-d'onde ou se résumer à un simple miroir constitué d'une couche métallique. Une combinaison d'un réflecteur de Bragg et d'un miroir peut être une solution intéressante également.

Le laser de l'invention est réalisé selon un procédé dans lequel on dépose tout d'abord sur un substrat un empilement alterné de couches d'un premier matériau semi-conducteur présentant un premier indice de réfraction et une première bande interdite, et d'un second matériau semi-conducteur présentant un second indice de réfraction et une seconde bande interdite.

Des techniques d'épitaxie comme les techniques à jet moléculaire (MBE) ou par dépôt organométallique (OMCVD) conviennent particulièrement bien à ce dépôt multicouche.

Dans un second temps on grave l'empilement pour laisser subsister un barreau vertical qui constitue la cavité optique.

Des techniques de gravure sèche du type RIE (*Reactive Ion Etching* ou gravure par ions réactifs) ou RIBE sont bien adaptées à ces gravures profondes.

Un revêtement constitué d'un troisième matériau d'indice de réfraction supérieur aux indices des premier et second matériau et de bande interdite supérieure à celle de ces matériaux est déposé autour du barreau afin de l'enrober. Les techniques d'épitaxie en phase liquide (LPE) ou en phase vapeur au chlorure sont des solutions intéressantes pour la réalisation de l'enrobage, notamment en raison des fortes anisotropies de vitesse de croissance qui les caractérise. Un soin tout particulier doit être apporté à ces opérations en raison des difficultés de "reprise" sur les faces latérales du barreau.

Sur le revêtement, on réalise encore un contact électrique, par exemple par dépôt d'une couche d'aluminium présentant une ouverture en regard du barreau. Une couche métallique est également déposée sur la face libre du substrat.

Le choix des matériaux semi-conducteurs utilisés pour la réalisation des couches de la cavité permet de s'adapter à différentes filières de laser.

Le tableau 1 donne des exemples de choix possible en particulier pour la filière d'émission de longueur d'onde 1,5 μm et celle de 0,9 μm.

Pour un matériau donné, la largeur de bande interdite ainsi que l'indice de réfraction optique peuvent être adaptés par un dopage adéquat.

## TABLEAU I

| Semi-conducteur | Premier matériau $(E_1, n1)$ | Second matériau $(E_2, n2)$ | Troisième matériau revêtement $(E_3, n3)$ |
|---|---|---|---|
| Filière 1,5μm | InGaAs ou InGaAsP (1,5μm) | InP ou InGaAsP (1,18μm) | InP |
| Idem | InAlAs ou GaAlInAs (1,5μm) | InAlAs ou GaAlInAs | InAlAs ou GaAlInAs |
| Filière 0,9μm | GaAs ou AlGaAs | AlAs ou AlGaAs | AlAs ou AlGaAs |

Le substrat est lui aussi choisi selon la filière retenue, il sera par exemple en phosphure d'indium (InP) pour la filière 1,5μm et en arséniure de gallium (AsGa) pour la filière 0,9μm.

Dans le cas de la filière 1,5μm, le premier matériau peut donc être choisi parmi les matériaux suivants : InGaAs, InGaAsP ou InGaAlAs, dont la composition est ajustée pour émettre avec une longueur d'onde comprise entre 1,3 et 1,6μm. Le second matériau est choisi par exemple parmi InP, InGaAsP ou InGaAlAs. La composition de ce matériau est ajustée pour lui conférer un indice de réfraction $n_2$ inférieur à l'indice $n_1$ du premier matériau. Cette composition correspond, par exemple à une émission avec une longueur d'onde comprise entre 1 et 1,2μm. Le troisième matériau, choisi par exemple parmi l'InP et InAlAs, présente un paramètre de maille accordé avec celui du substrat, soit, dans le cas de la filière 1,5μm, le paramètre de maille de l'InP, par exemple.

D'autres caractéristiques et avantages de l'invention seront décrits à l'aide des figures données à titre purement indicatif et nullement limitatif, sur lesquelles :

- la figure 1A est une coupe schématique à grande échelle d'un dispositif d'émission laser selon l'invention, et représente un empilement de couches ;
- la figure 1B représente les marches d'indices fermées par les couches et la propagation de l'onde lumineuse,
- la figure 2 est une coupe à plus petite échelle d'une variante de réalisation du dispositif,
- la figure 3 est une coupe d'un dispositif laser selon l'invention et représente schématiquement un circuit électrique équivalent du dispositif,
- la figure 4 représente des courbes exprimant le courant de seuil du laser en fonction de la longueur de sa cavité pour différentes longueurs d'onde.

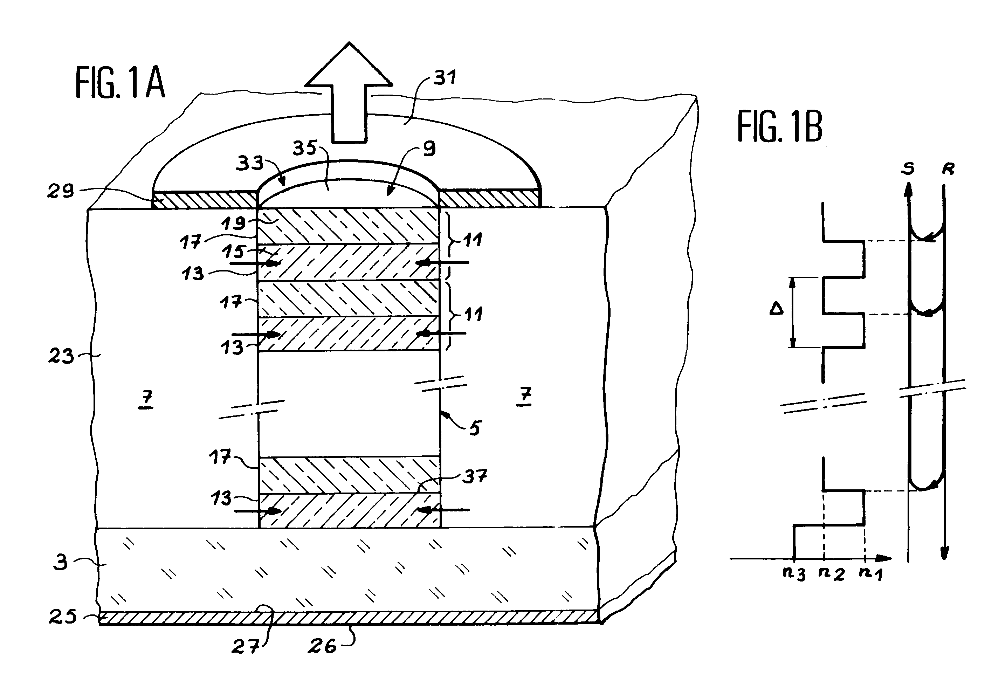

Comme l'illustre la figure 1, le laser de l'invention comprend un substrat 3 supportant une cavité 5 perpendiculaire au substrat 3 et dite verticale, et un revêtement 7 enrobant la cavité 3. La cavité 3 qui est de forme générale cylindrique, ou éventuellement parallélépipédique, présente selon le cas une ou plusieurs faces dites verticales, c'est-à-dire perpendiculaires au substrat 3 et deux faces parallèles au substrat. L'une ou les deux faces parallèles peuvent constituer une surface d'émission de lumière. la cavité est formée d'un empilement alterné 9 de couches semi-conductrices. L'empilement 9 comporte des paires 11 de couches, formées chacune d'une première couche 13 d'un premier matériau 15 semiconducteur dopé de type N de bande interdite $E_1$ et d'indice de réfraction $n_1$ et d'une deuxième couche 17 d'un deuxième matériau 19 semi-conducteur dopé de type N de bande interdite $E_2$ et d'indice de réfraction $n_2$.

Le revêtement 7 est réalisé en un troisième matériau semi-conducteur 23 de bande interdite $E_3$ supérieure à $E_1$ et $E_2$ et d'indice de réfraction inférieur à $n_1$ et $n_2$.

Une couche 25 en un matériau conducteur constitue une électrode 26 sur la face inférieure 27 du substrat 3 tandis qu'une autre couche 29 également en un matériau conducteur constitue une électrode 31 sur le revêtement 7.

La couche 29 comporte une ouverture 33 en regard de la cavité 3. L'ouverture 33 délimite une face frontale 35 d'émission de lumière constitué par la dernière couche 17' de l'empilement.

La figure 1B représente les marches d'indices constituées par les différentes couches les couches 13 et 17 ayant respectivement un indice $n_1$ et $n_2$.

Quand des porteurs électriques, représentés par des flèches sur la figure 1A, sont injectés dans les couches 13 qui constituent les zones actives du dispositif, celles-ci génèrent des photons (du gain optique) à la longueur d'onde associée à la bande $E_1$ du matériau 15. La lumière, guidée par le revêtement 7 dont le matériau 23 présente un indice $n_3$ inférieur aux indices $n_1$, $n_2$ des matériau 15 et 19, se propage le long de la cavité 9. A chaque interface entre une couche 17 (ou 17') et une couche 13 une onde lumineuse désignée par R se propageant de haut en bas le long de la cavité 9 est partiellement réfléchie en passant d'une couche 17 d'indice supérieur $(n_1)$ à une couche 13 d'indice inférieur $(n_2)$ et se transforme en une onde désignée par S qui se propage de bas en haut. De même une partie de l'onde S se transforme aussi en onde R. Ce phénomène traduit la réaction distribuée dans les couches.

L'injection latérale d'un courant de porteurs électriques des couches 13, doit permettre d'obtenir un gain suffisant pour compenser les pertes dans la cavité 5 et entretenir une oscillation laser perpendiculaire aux couches 13, 17.

Le couplage de la lumière avec le réseau constitué par l'empilement 9 de couches 13, 17 dépend essentiellement de la différence d'indice $n_1$-$n_2$.

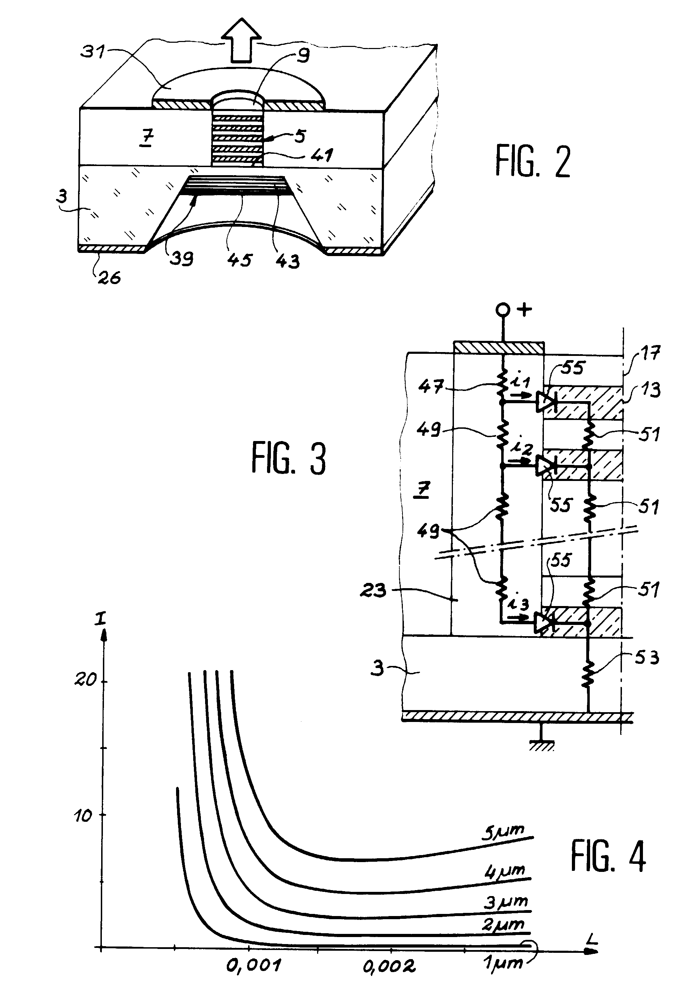

La figure 2 montre une variante de l'invention où le substrat 3 est gravé et où on a réalisé un miroir 39 disposé en regard de face 41 de la cavité 9 adjacente au substrat 3.

Le miroir 39 se compose d'un empilement 43 quart-d'onde de couches de silicium et d'oxyde de silicium, et d'une couche réflectrice métallique 45.

La figure 3 illustre le fonctionnement électrique du laser. On désigne par $i_1$, $i_2$ ... $i_n$ les courants de porteurs injectés latéralement dans les couches 13 constituant les régions actives du laser lorsqu'une tension positive est appliquée entre les électrodes 31 et 26.

On désigne par 47 et 49 les résistances d'un pont diviseur formé par le revêtement 7 et distribuant les courants $i_1$, $i_2$, ... $i_n$ vers les couches 13. Les valeurs des résistances 47, 49 sont fixées par la résistivité du matériau 23 et de la taille du revêtement 7. On désigne par ailleurs par 51 des résistances formées par les couches 17 de matériau 19.

Les résistances 51 sont essentiellement déterminées par la taille des couches 17.

On désigne enfin par 55 des diodes fermées aux jonctions entre le matériau 23 et les couches 13 de matériau 15.

A priori, et dans un cas idéal toutes les résistances 49, et éventuellement la résistance 47 reliant le revêtement 7 à l'électrode 31 sont de valeurs égales. De même les résistances 51 devraient toutes avoir la même valeur. Ces conditions étant réunies tous les courants $i_1$, $i_2$, ..., $i_n$ sont identiques et le laser fonctionne de façon optimale.

Le fonctionnement du laser est bien sûr sensible à la qualité des jonctions entre les différents matériaux.

Néanmoins les spécifications des caractéristiques des matériaux fixant la valeur des résistances 49 et 51 acceptent de bonnes tolérances en raison de la saturation du niveau de Fermi induite par l'émission stimulée. Au seuil laser, toutes les diodes 51 ont la même tension à leurs bornes et les courants $i_1$, ..., $i_n$ injectés dans les couches 13 sont quasiment identiques.

Dans un cas particulier ou les couches 13 et 17 en GaInAsP présentent une différence d'indice n1-$n_2$ égal à 0,33, où le facteur de recouvrement entre l'onde stationnaire et les couches 13 est égal à 1, et où le coefficient de couplage de la lumière avec le réseau formé par l'empilement est de 7000 cm$^{-1}$ pour une émission de longueur d'onde 1,5 $\mu$m, les courbes de la figure 4 donnent en milliampères les courants de seuil I circulant entre les électrodes 26 et 31, en fonction de la longueur L en centimètres de la cavité, pour différents diamètres de cavité (1 $\mu$m à 5 $\mu$m).

**Revendications**

1. Laser intégré à émission par la surface comportant un substrat (3) et une cavité optique (5) à rétroaction distribuée présentant au moins une face latérale perpendiculaire au substrat et au moins une face d'émission de lumière parallèle au substrat, la cavité comprenant un empilement (9) de couches (13, 15) semi-conductrices de différents indices de réfraction, avec des régions optiquement actives, et la face latérale étant enrobée par un revêtement (7) semiconducteur, caractérisé en ce que le revêtement (7) et le substrat (3) sont respectivement en contact électrique avec des électrodes (31, 26) formées sur le revêtement et sur une face libre du substrat pour appliquer une tension entre le revêtement et le substrat, le revêtement formant ainsi un moyen d'injection d'un courant de porteurs électriques dans les régions optiquement actives, par la face latérale de la cavité, et le courant de porteurs électriques s'écoulant vers le substrat (3) à travers la cavité (5).

2. Laser selon la revendication 1, caractérisé en ce que l'empilement comporte des paires (11) de couches formées chacune d'une première couche (13) d'un premier matériau semi-conducteur ayant une première bande interdite $E_1$ et un premier indice de réfraction $n_1$, et d'une deuxième couche (15) d'un second matériau semi-conducteur ayant une deuxième bande interdite $E_2$ et un deuxième indice de réfraction $n_2$ différent du premier indice de réfraction $n_1$ du premier matériau, ladite couche (13) de premier matériau de chaque paire constituant une des régions optiquement actives du laser.

3. Dispositif selon la revendication 2, caractérisé en ce que le revêtement est réalisé en un troisième matériau semi-conducteur (23) présentant un troisième indice de réfraction $n_3$ inférieur aux premier et deuxième indices de réfraction $n_1$ et $n_2$ respectivement des premier et second matériaux.

4. Laser selon la revendication 2 ou 3, caractérisé en ce que le premier matériau est choisi parmi les matériaux suivants : InGaAs, InGaAsP et InGaAlAs dont la composition est ajustée pour émettre avec une longueur d'onde comprise entre 1,3 et 1,6µm.

5. Laser selon la revendication 2 ou 3, caractérisé en ce que le second matériau est choisi parmi les matériaux suivants : InP, InGaAsP et InGaAlAs de composition correspondant à une émission avec une longueur d'onde comprise entre 1 et 1,2µm.

6. Laser selon la revendication 3, caractérisé en ce que le troisième matériau est choisi parmi les matériaux suivants : InP, InAlAs, accordé en paramètre de maille à InP.

7. Laser selon l'une des revendications 2 ou 3, dans lequel une longueur d'onde de Bragg λ est associé à l'empilement (9) qui présente un indice de propagation effectif de la lumière perpendiculairement aux couches (13, 15), caractérisé en ce que les paires de couches (11) présentent une épaisseur égale à la moitié du rapport de la longueur d'onde de Bragg de l'empilement λ sur l'indice de propagation de la lumière $n_{eff}$ perpendiculairement aux couches.

8. Laser selon la revendication 1, caractérisé en ce que l'électrode en contact avec le revêtement comporte une couche de matériau conducteur électrique formée sur le revêtement et présentant une ouverture en regard de la cavité.

9. Laser selon la revendication 1, caractérisé en ce qu'il comporte en outre des moyens de réflexion (39) externes à la cavité.

10. Laser selon la revendication 9, caractérisé en ce que les moyens de réflexion comportent plusieurs couches diélectriques quart-d'onde (43) et une couche métallique (45), déposée sur une face frontale de la cavité parallèle à la face frontale d'émission.

11. Procédé de réalisation d'un laser conforme à la revendication 1, caractérisé en ce qu'il comprend les étapes suivantes :

   - formation sur un substrat d'un empilement de couches d'un premier et d'un deuxième matériau semiconducteur présentant respectivement une première bande interdite et une deuxième bande interdite,
   - gravure de cet empilement pour laisser subsister un barreau vertical,
   - formation autour du barreau d'un revêtement en un troisième matériau semi-conducteur (23) ayant une troisième bande interdite,
   - dépôt sur le revêtement d'un contact électrique (31) présentant une ouverture (33) en regard du barreau.

12. Procédé de réalisation d'un laser selon la revendication 11, caractérisé en ce qu'on forme l'empilement de couches par épitaxie de jets moléculaires.

13. Procédé de réalisation d'un laser selon la revendication 11, caractérisé en ce que l'on forme l'empilement de couches par une technique de dépôt en phase vapeur.

14. Procédé de réalisation d'un laser selon l'une des revendications 11, caractérisé en ce que la gravure des couches est réalisée par une technique de gravure sèche.

15. Procédé de réalisation d'un laser selon l'une quelconque des revendications 11, caractérisé en ce que la formation du revêtement est réalisée par épitaxie en phase liquide ou vapeur.

**Patentansprüche**

1. Integrierte oberflächenemittierende Laservorrichtung, ein Substrat (3) und einen optischen Resonator (5) mit verteilter Rückkopplung umfassend, der wenigstens eine zum Substrat senkrechte Seitenfläche und wenigstens eine zum Substrat parallele Emissionsfläche aufweist, wobei der Resonator einen Stapel (9) von Halbleiterschichten (13, 15) mit unterschiedlichen Brechzahlen umfaßt, mit optisch aktiven Zonen, und die Seitenfläche mit einem Überzug (7) beschichtet ist,
   **dadurch gekennzeichnet,**
   daß der Überzug (7) und das Substrat (3) jeweils elektrischen Kontakt haben mit Elektroden (31, 26), ausgebildet auf dem Überzug und auf einer freien Fläche des Substrats, um zwischen dem Überzug und dem Substrat eine Spannung anzulegen, wobei der Überzug dann eine Einrichtung zum Einspeisen eines Stroms elektrischer Ladungsträger in die optisch aktiven Zonen bildet, durch die Seitenfläche des Resonators, und der Strom elektrischer Ladungsträger in Richtung Substrat (3) fließt, durch den Resonator (5).

2. Laservorrichtung nach Anspruch 1, dadurch gekennzeichnet, daß der Stapel Schichtenpaare (11) umfaßt, jedes gebildet durch eine erste Schicht (13) aus einem ersten Halbleitermaterial mit einem ersten verbotenen Band $E_1$ und einer ersten Brechzahl $n_1$, und einer zweiten Schicht (15) aus einem zweiten Halbleitermaterial mit einem zweiten verbotenen Band $E_2$ und einer zweiten Brechzahl $n_2$, verschieden von der ersten Brechzahl $n_1$ des ersten Materials, wobei die Schicht (13) des ersten Materials jedes Paars eine der optisch aktiven Zonen des Lasers bildet.

3. Laservorrichtung nach Anspruch 2, dadurch gekennzeichnet, daß der Überzug aus einem dritten Halbleitermaterial (23) hergestellt wird, das eine dritte Brechzahl $n_3$ aufweist, niedriger als die erste und die zweite Brechzahl $n_1$ und $n_2$ des jeweils ersten und zweiten Materials.

4. Laservorrichtung nach Anspruch 2 oder 3, dadurch gekennzeichnet, daß das erste Material ausgewählt wird unter folgenden Materialien: InGaAs, InGaAsP und UnGaAlAs, deren Zusammensetzung angepaßt wird, um mit einer Wellenlänge zwischen 1,3 und 1,6μm zu emittieren.

5. Laservorrichtung nach Anspruch 2 oder 3, dadurch gekennzeichnet, daß das zweite Material ausgewählt wird unter folgenden Materialien: InP, InGaAsP und InGaAlAs mit einer Zusammensetzung, die einer Emission mit einer Wellenlänge zwischen 1 und 1,2μm entspricht.

6. Laservorrichtung nach Anspruch 3, dadurch gekennzeichnet, daß das dritte Material ausgewählt wird unter folgenden Materialien: InP, InAlAs, gitterangepaßt an InP.

7. Laservorrichtung nach einem der Ansprüche 2 oder 3, bei der dem Stapel (9) eine Bragg-Wellenlänge λ zugeordnet wird, die eine effektive Brechzahl des sich senkrecht zu den Schichten (13, 15) ausbreitenden Lichts aufweist, dadurch gekennzeichnet, daß die Schichtenpaare (11) eine Dicke bzw. ein Dickenverhältnis gleich der Hälfte des Verhältnisses der Bragg-Wellenlänge λ des Stapels zur Brechzahl $n_{eff}$ des sich senkrecht zu den Schichten ausbreiteten Lichts aufweist.

8. Laservorrichtung nach Anspruch 1, dadurch gekennzeichnet, daß die Elektrode, die sich in Kontakt mit dem Überzug befindet, eine Schicht aus elektrisch leitendem Material umfaßt, gebildet auf dem Überzug und eine Öffnung gegenüber dem Resonator aufweisend.

9. Laservorrichtung nach Anspruch 1, dadurch gekennzeichnet, daß sie außerdem Reflexionseinrichtungen (39) außerhalb des Resonators umfaßt.

**10.** Laservorrichtung nach Anspruch 9, dadurch gekennzeichnet, daß die Reflexionseinrichtungen mehrere dielektrischen Viertelwellenlängen-Schichten (43) und eine Metallschicht (45) umfassen, abgeschieden auf einer vorderen Fläche des Resonators, parallel zu der vorderen Emissionsfläche.

**11.** Verfahren zur Herstellung einer Laservorrichtung nach Anspruch 1, dadurch gekennzeichnet, daß es die folgenden Schritte umfaßt:

- Bilden eines Schichtenstapels aus einem ersten und einem zweiten Material mit jeweils einem ersten verbotenen Band und einem zweiten verbotenen Band auf einem Substrat,
- Ätzen dieses Stapels, so, daß ein vertikaler Stab bestehen bleibt,
- Bilden eines Überzugs, um den Stab herum, aus einem dritten Halbleitermaterial (23) mit einem dritten verbotenen Band,
- Abscheiden, auf dem Überzug, eines elektrischen Kontakts (31) mit einer Öffnung (33) gegenüber dem Stab.

**12.** Verfahren nach Anspruch 11, dadurch gekennzeichnet, daß man den Schichtenstapel durch Molekularstrahl-Epitaxie bildet.

**13.** Verfahren nach Anspruch 11, dadurch gekennzeichnet, daß man den Schichtenstapel durch eine Gasphasenabscheidungstechnik bildet.

**14.** Verfahren nach Anspruch 11, dadurch gekennzeichnet, daß das Ätzen der Schichten durch eine Trockenätztechnik erfolgt.

**15.** Verfahren nach Anspruch 11, dadurch gekennzeichnet, daß man den Überzug durch Flüssig- oder Gasphasenepitaxie bildet.

## Claims

**1.** Integrated surface-emitting laser, comprising a substrate (3) and a distributed feedback optical cavity (5) having at least one side face perpendicular to the substrate and at least one light-emitting face parallel to the substrate, the cavity consisting of a stack (9) of semiconductor layers (13, 15) of various refractive indices, with optically active regions, and the side face being coated with a semiconductor coating (7), characterized in that the coating (7) and the substrate (3) are respectively in electrical contact with electrodes (31, 26) formed on the coating and on a free face of the substrate in order to apply a voltage between the coating and the substrate, the coating thus forming a means of injecting a current of electrical carriers into the optically active regions, via the lateral face of the cavity, and the current of electrical carriers flowing to the substrate (3) through the cavity (5).

**2.** Laser according to Claim 1, characterized in that the stack comprises pairs (11) of layers, each one formed by a first layer (13) of a first semiconductor material having a first band gap $E_1$ and a first refractive index $n_1$ and by a second layer (15) of a second semiconductor material having a second band gap $E_2$ and a second refractive index $n_2$ different from the first refractive index $n_1$ of the first material, the said layer (13) of first material of each pair constituting one of the optically active regions of the laser.

**3.** Laser according to Claim 2, characterized in that the coating is made of a third semiconductor material (23) having a third refractive index $n_3$ which is less than the first and second refractive indices $n_1$ and $n_2$ of the first and second materials respectively.

**4.** Laser according to Claim 2 or 3, characterized in that the first material is chosen from the following materials: InGaAs, InGaASP and InGaAlAs, the composition of which is adjusted to emit at a wavelength of between 1.3 and 1.6 µm.

**5.** Laser according to Claim 2 or 3, characterized in that the second material is chosen from the following materials: InP, InGaASP and InGaAlAs of composition corresponding to emission at a wavelength of between 1 and 1.2 µm.

**6.** Laser according to Claim 3, characterized in that the third material is chosen from the following materials: InP and InAlAs, matched in terms of unit-cell parameter to InP.

7. Laser according to either of Claims 2 and 3, in which a Bragg wavelength $\lambda$ is associated with the stack (9) which has an effective index for propagating light perpendicularly to the layers (13, 15), characterized in that the pairs of layers (11) have a thickness equal to half the ratio of the Bragg wavelength $\lambda$ of the stack to the index $n_{eff}$ for propagating light perpendicularly to the layers.

8. Laser according to Claim 1, characterized in that the electrode in contact with the coating comprises a layer of electrically conductive material formed on the coating and having an aperture opposite the cavity.

9. Laser according to Claim 1, characterized in that it furthermore comprises reflection means (39) external to the cavity.

10. Laser according to Claim 9, characterized in that the reflection means comprise several quarter-wave dielectric layers (43) and a metal layer (45) which is deposited on a front face of the cavity parallel to the front emitting face.

11. Process for fabricating a laser in accordance with Claim 1, characterized in that it includes the following steps:

  - forming a stack of layers of a first and a second semiconductor material on a substrate, these layers having respectively a first band gap and a second band gap;
  - etching this stack in order to leave a vertical bar;
  - forming a coating made of a third semiconductor material (23) around the bar, this material having a third band gap;
  - depositing an electrical contact (31) on the coating, this contact having an aperture (33) opposite the bar.

12. Process for fabricating a laser according to Claim 11, characterized in that the stack of layers is formed by molecular beam epitaxy.

13. Process for fabricating a laser according to Claim 11, characterized in that the stack of layers is formed using a vapour deposition technique.

14. Process for fabricating a laser according to one of Claims 11 to 13, characterized in that the layers are etched using a dry etching technique.

15. Process for fabricating a laser according to any one of Claims 11 to 14, characterized in that the coating is formed by liquid or vapour phase epitaxy.

FIG. 1A

FIG. 1B

31

35 9

33

29

19
17 15
13

17

13

17

13

11

11

37

23

7 7

5

3

25

27 26

S R

Δ

$n_3$ $n_2$ $n_1$

EP 0 651 477 B1

FIG. 2

FIG. 3

FIG. 4